(19) Europäisches Patentamt / European Patent Office / Office européen des brevets

(11) **EP 2 320 154 A1**

(12) **EUROPEAN PATENT APPLICATION**
published in accordance with Art. 153(4) EPC

(43) Date of publication:
**11.05.2011 Bulletin 2011/19**

(51) Int Cl.:
*F24J 2/18* (2006.01)    *F24J 2/38* (2006.01)
*G02B 7/182* (2006.01)    *H01L 31/042* (2006.01)

(21) Application number: **09802875.6**

(22) Date of filing: **23.07.2009**

(86) International application number:
**PCT/JP2009/063154**

(87) International publication number:
**WO 2010/013632 (04.02.2010 Gazette 2010/05)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **31.07.2008 JP 2008197955**

(71) Applicants:
• **Cosmo Oil Co., Ltd.**
  **Tokyo 105-8528 (JP)**
• **Abu Dhabi Future Energy Company PJSC**
  **Abu Dhabi (AE)**

(72) Inventors:
• **YUASA, Minoru**
  **Tokyo 105-8528 (JP)**
• **HASUIKE, Hiroshi**
  **Tokyo 152-8550 (JP)**
• **TAMAURA, Yutaka**
  **Tokyo 152-8550 (JP)**

(74) Representative: **HOFFMANN EITLE**
**Patent- und Rechtsanwälte**
**Arabellastraße 4**
**81925 München (DE)**

(54) **METHOD FOR COLLECTING SUNLIGHT IN MULTI-TOWER BEAM DOWN TYPE LIGHT COLLECTING SYSTEM**

(57)    It enhances heat collecting efficiency of sunlight received by heliostats. It is a solar light collecting method in a multi-tower beam-down light collecting system, including a tower selection. The multi-tower beam-down light collecting system is a system in which, in a field where a plurality of beam-down light collecting towers are present, light primarily reflected by heliostats 1 around each tower 4 is secondarily reflected by a reflector 3 at a top part of the tower 4 and is collected on a receiver 3 on the ground, and the tower selection is a process in which, assuming that the heliostat 1 in a given position receives sunlight and reflects the sunlight toward each of optionally selected two of the towers 4, 4, a light receiving quantity on the receiver 3 of each of the towers 4 is compared, and one of the towers 4 in which the light receiving quantity is relatively large is selected to reflect the sunlight toward the one of the towers 4.

*FIG. 4(a)*

FIG. 4(b)

**Description**

TECHNICAL FIELD

The present invention relates to a method of enhancing light collecting efficiency of solar energy in a multi-tower beam-down light collecting system.

BACKGROUND ART

Of renewable natural energy, solar thermal energy is very promising as energy to replace fossil fuel, owing to its abundant potential quantity (potential quantity of energy resource). The intensity of solar thermal energy, though it varies depending on locations, is about $1kW/m^2$. Thermal energy of sunlight can be sufficiently utilized as an energy source for operating a thermochemical reaction plant, a power generation plant or the like. In order to utilize the solar thermal energy as an energy source, it is required to be efficiently converted into chemical energy or electric energy, and in order to enhance the conversion efficiency, it is required to efficiently collect the sunlight.

The position of the sun relative to a point on the ground changes over time due to the rotation of the earth. Therefore, in order to collect the sunlight and to collect solar energy efficiently, it is required to track the sun. A device for tracking the sun is called a heliostat.

In conventional heliostat sun-tracking-systems, a centralized control of each heliostat through wire and wireless communication, or a control by means of optical sensors have been performed.

In order to collect sunlight and to efficiently obtain the thermal energy, it is required to make the heliostats accurately track the position of the sun. The energy obtained by collecting the sunlight is theoretically proportional to the total area of mirror surfaces of the heliostats. Therefore, an issue in installing the heliostats is that, in order to obtain large quantity of energy, it is necessary to increase the mirror surface area of the heliostats or to increase the number of heliostats.

When obtaining thermal energy of collected sunlight using a large number of heliostats, it is necessary to make each heliostat track the sun, and to concentrate the reflection light of the sunlight received in each heliostat at one point while controlling the orientation of each heliostat.

Meanwhile, systems for collecting the sunlight received in heliostats are classified broadly into a tower-top light collecting system and a beam-down light collecting system. The tower-top light collecting system includes a heliostat group and a receiver disposed on a tower top, and is a system which collects the light reflected by the heliostat group at the receiver on the tower top. The beam-down light collecting system includes a heliostat group, a reflector disposed on a tower top, and a receiver disposed on the ground, and is a system which secondarily reflects the sunlight, which has been primarily reflected by the heliostat group, and collects the light on the receiver.

Further, the tower-top light collecting systems are classified, on the basis of the shape of the receiver (heat collector), into three types, namely, a flat receiver type, a cavity receiver type, and a cylindrical receiver type. In the flat receiver type, a flat receiver (heat collector) is arranged on a top part of a tower vertically and northwardly (in a case of the northern hemisphere), and heliostats are arranged only on the north side of the tower to collect the reflection light on the receiver on the tower. In the cavity receiver type, a cavity receiver (heat collector) is arranged on a top part of a tower so that an opening thereof faces northward and obliquely downward (in a case of the northern hemisphere), and heliostats are arranged only on the north side of the tower to collect the reflection light on the receiver on the tower. In the cylindrical receiver type, a cylindrical heat collector is arranged on a top part of a tower, and heliostats are arranged around the tower to collect the light reflected from the respective heliostats on the receiver on the tower.

On the other hand, according to the beam-down light collecting system, which includes a heliostat group, a reflector and a receiver, and is a system in which the light primarily reflected by the heliostat group is secondarily reflected by the reflector on a top part of the tower and the secondarily-reflected light is collected on the receiver arranged on a bottom part of the tower (on the ground), arranging the heliostats around the tower enables light collection from periphery of the tower (see Patent Document 1 to 3).

In the beam-down light collecting system, two or more towers may be arranged at intervals among the heliostats that are dispersedly arranged on the ground, and this is called as a multi-tower beam-down light collecting system.

Also, in the cylindrical receiver type tower-top light collecting system, two or more towers may be arranged at intervals among the heliostats that are dispersedly arranged on the ground, and this is called as a multi-tower tower-top light collecting system.

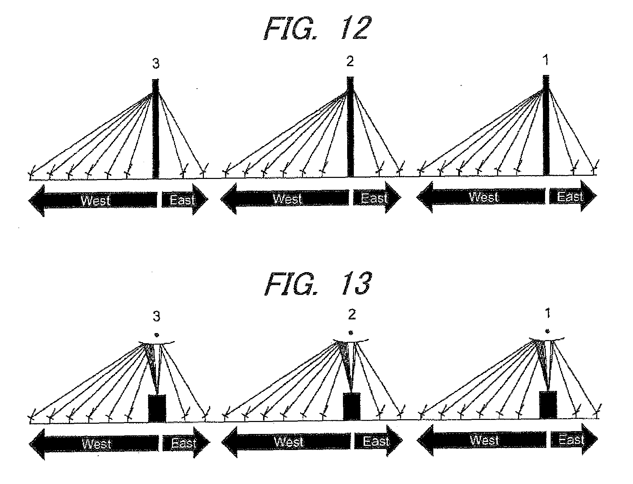

When comparing the functions of the multi-tower tower-top light collecting system and the multi-tower beam-down light collecting system, as for the multi-tower tower-top light collecting system, in a case in which the heliostats are continuously arranged in the east-west direction as shown in Fig. 12 and the sun is on the east side for example, there is a large difference in light collecting quantity between the east-side surface and the west-side surface of the receiver (heat collector) on the top part of the tower.

In such a case, on the east-side surface of the heat collector, the light collecting quantity becomes deficient, with the result that the heat collecting efficiency decreases significantly. To the contrary, in the multi-tower beam-down light collecting system, as shown in Fig. 13, the light from the heliostats disposed in any direction is, in theory, collected uniformly on the upper surface of the receiver that is disposed on a bottom part of the tower. Therefore, it is possible to suppress the decrease of the heat collecting efficiency due to the shortage of the light collecting quantity which is caused in the multi-tower tower-top light collecting system, whereby high heat-collecting efficiency is obtained.

For such reason, the multi-tower beam-down light collecting system is advantageous as compared with the multi-tower tower-top light collecting system. Nevertheless, the advantage of the multi-tower beam-down light collecting system is only in comparison with the heat collecting efficiency of the multi-tower tower-top light collecting system.

    Patent Document 1: JP 2951297 B2
    Patent Document 2: JP 2000-146310 A
    Patent Document 3: JP 2004-37037 A

DISCLOSURE OF THE INVENTION

PROBLEM THAT THE INVENTION IS TO SOLVE

While the multi-tower beam-down light collecting system is advantageous as compared with the multi-tower tower-top light collecting system, this is only in comparison with the multi-tower tower-top light collecting system, and a problem that the invention is to solve is that there is room for further improvement also in the multi-tower beam-down light collecting system.

MEANS FOR SOLVING THE PROBLEM

The most distinctive feature of the present invention is to select, in a multi-tower beam-down light collecting system, a tower toward which a heliostat reflects light, in accordance with according a position of the sun so as to increase light collecting quantity.

More specifically, the present invention is a solar light collecting method in a multi-tower beam-down light collecting system, having a tower selection,
the multi-tower beam-down light collecting system being a system in which, in a field where a plurality of beam-down light collecting towers are present, light primarily reflected by a heliostat is secondarily reflected by a reflector at a top part of one of the towers and is collected on a receiver on the ground, and
in which the tower selection includes comparing, assuming that the heliostat in a given position receives sunlight and reflects the sunlight toward each of optionally selected two of the towers, a light receiving quantity on the receiver of each of the towers, and selecting one of the towers in which the light receiving quantity is relatively large to reflect the sunlight toward the one of the towers.

As a practically simple method, for example, the tower may be selected such that, assuming that the heliostat in a given position receives the sunlight and reflects the sunlight toward each of the optionally selected two of the towers, an angle formed by an directional vector of incident light and a directional vector of reflection light seen from the heliostat is compared, the magnitude of the angle formed by the directional vector of the incident light and the directional vector of the reflection light seen from the heliostat is evaluated, and a tower with respect to which the angle formed by the directional vector of the incident light and the directional vector of the reflection light seen from the heliostat is smaller is determined as the tower in which the light receiving quantity is relatively large.

ADVANTAGE OF THE INVENTION

According to the present invention, in the multi-tower beam-down light collecting system, each of the heliostats that are dispersedly arranged on the ground are made to select the tower toward which the reflected sunlight is to be collected, whereby conversion efficiency of the solar energy can be enhanced.

BRIEF DESCRIPTION OF THE DRAWINGS

    Fig. 1 is a diagram showing a basic structure of a beam-down light collecting system as a solar light collecting system using heliostats;
    Fig. 2 is a diagram showing an example of a configuration of a heliostat;

Fig. 3 is a diagram showing an example of a configuration of a reflector;

Fig. 4(a) is a plan view showing an example of a configuration of a multi-tower beam-down light collecting system, and Fig. 4(b) is a sectional view taken along the line A-A in Fig. 4(a);

Fig. 5 is a diagram showing a relation between a tower to be selected and a position of the sun;

Fig. 6 is a diagram showing an example in which a tower, toward which sunlight is to be reflected, is selected based on the magnitude of an angle formed by the sun S and a neighboring tower seen from an heliostat;

Fig. 7 is a diagram showing an example in which a tower having larger light receiving quantity on the receiver is selected from the respective towers;

Fig. 8 is a diagram showing a case in which two towers are lined on the east and west as a calculation example of tower selection using a light collecting simulator;

Fig. 9 is a diagram showing a comparison of reflected energy quantity between when a tower toward which the sunlight is to be reflected is selected and when not selected;

Fig. 10 is a diagram showing a rate of the reflected energy quantity increased by selecting the tower toward which the sunlight is to be reflected;

Fig. 11 shows the reflected energy quantity from a heliostat in a day, in which (a) is a diagram showing the reflected energy quantity in a case of a single-tower light collecting system, and (b) is a diagram showing the reflected energy quantity in a case in which a tower selection is carried out successively such that an angle formed by a reflector (upper focus) and the sun seen from a heliostat becomes smaller;

Fig. 12 is a diagram showing a light collection in a multi-tower tower-top light collecting system; and

Fig. 13 is a diagram showing a light collection in a multi-tower beam-down light collecting system.

## EMBODIMENTS OF THE INVENTION

An object to select a tower such that light receiving quantity becomes the largest when a heliostat receives sunlight of the sun in a given position is achieved by evaluating the magnitude of the light receiving quantity on a receiver of the tower, finding a relation between a position of the sun and a tower to be selected, and controlling the heliostat.

## EMBODIMENT 1

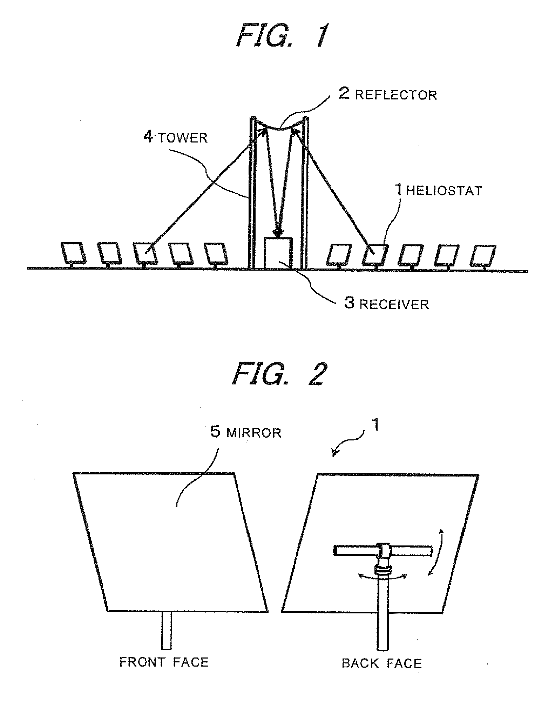

A multi-tower beam-down light collecting system is a system in which, in a field where a plurality of beam-down light collecting towers are present, light primarily reflected by heliostats around each tower is secondarily reflected by a reflector on a top part of the tower to collect the light on a receiver on the ground. Fig. 1 shows a basic structure of a beam-down light collecting system as a solar light collecting system using heliostats. In Fig. 1, the beam-down light collecting system is configured by a combination of a group of heliostats 1, 1, ... dispersedly arranged on the ground and a tower 4 including a reflector 2 and a receiver 3. The reflector 2 is a reflection mirror disposed in a position of an upper focus at a top part of the tower 4, and the receiver 3 is disposed in a position of a lower focus at a bottom part of the tower 4 (on the ground) so as to face the reflector 2. The beam-down light collecting system is a system in which the sunlight primarily reflected by the heliostats 1 is secondarily reflected by the reflector 2, thereby collecting the light on the receiver 3.

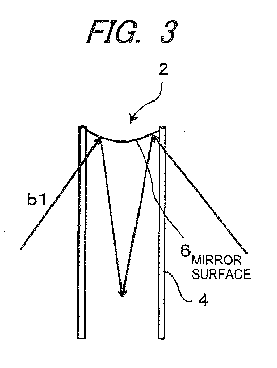

The heliostat (a primary reflection mirror) I is, as shown in Fig. 2, a device which can orient a mirror 5 in any direction to reflect the sunlight in the direction toward which the mirror 5 is oriented. The reflector (a central reflection mirror, a secondary reflection mirror) 2 is, as shown in Fig. 3, a device which reflects again the sunlight b1 reflected from the heliostat 1 toward the receiver 3 by a mirror surface 6. The reflector 2 may be a hyperboloid-of-revolution type, a segment type or the like. Further, the receiver 3 is a light collector for receiving the collected light, and is classified into a flat type, a cylindrical type, a cavity type, and the like based on its shape.

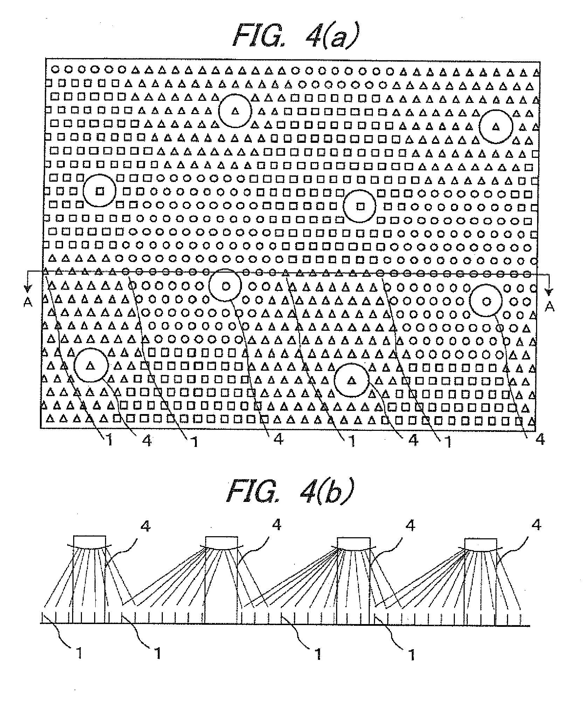

Fig. 4 shows an example of a configuration of the multi-tower beam-down light collecting system. The multi-tower beam-down light collecting system is configured by a combination of the tower 4 and a group of heliostats 1, 1... around the tower 4. According to the present invention, the combination of the tower targeted by each heliostat and the respective heliostats is not necessarily identified. Therefore, as an embodiment, the towers are arranged at certain intervals among groups of heliostats 1, 1... arranged dispersedly on the ground.

According to the present invention, each of the heliostats 1 selects, from some of the towers 4 set up nearby, a specified tower 4 such that the light receiving quantity on the receiver becomes the largest, and sends forth the reflected sunlight toward the reflector 2 of the specified tower 4 that has been selected. This will be referred to as a tower selection.

More specifically, the tower selection is a process in which, the light receiving quantity on the receiver 3 of the tower 4 is compared, assuming that the heliostat 1 in a given position receives the sunlight and reflects the sunlight toward each of optionally selected two towers 4, 4, and the tower 4 in which the light receiving quantity is relatively large is selected to reflect the sunlight toward that tower 4.

Fig. 4(a) shows a relation between the heliostats 1 arranged dispersedly on the ground and a tower to be selected by each group of heliostats 1 at a given time. In Fig. 4(a), large circles show the towers 4 each including the reflector 2 and the receiver 3, and small circles, triangles and rectangles therearound show the heliostats 1. Circular, triangular and rectangular marks indicated inside the respective large circles show that the tower is selected by the heliostats 1 of the same mark.

While the heliostats 1 are aligned in the longitudinal and lateral directions in this drawing, a group of heliostats that targets the same tower forms a hexagonal formation, and the tower 4 which collects the light is located in the lower right position therein. When focusing attention on the individual heliostats, each of the heliostats 1 reflects the sunlight toward the selected tower in accordance with the tower selection, regardless of the distance to the tower as shown in Fig. 4(b), and the selected tower 4 collects the sunlight received on the reflector 2 at the receiver 3 on the ground.

The collected sunlight is thermally stored, for example, in molten salt through the receiver (heat collector) and is used for various purposes. Alternatively, the collected sunlight is further collected by a secondary light collector called CPC and, thereafter, produces chemical energy fuel through an endothermic chemical reaction in a chemical energy conversion receiver (heat collector for chemical energy conversion).

In order to make the heliostat 1 reflect the sunlight toward the selected tower 4, the orientation of the heliostat 1 is controlled. The orientation control is performed by a calendar method and/or a sensor method described below.

(a) Calendar Method

Among the methods in which a directional vector of the heliostat is calculated from coordinates of the heliostat, coordinates of a target, and a directional vector of the sun to control the orientation so as to face in that direction, the calendar method is a method in which the directional vector of the sun is calculated from the latitude, longitude and the time. This calculation may be performed either independently for each heliostat or on a computer which centrally controls the plurality of heliostats.

(b) Sensor Method

The sensor method is a method of controlling the orientation of the heliostat using a reflection light sensor provided in each heliostat. Since this method is not influenced by the installation error of the heliostat or an error in a control mechanism, it can perform the control with good accuracy. However, when using the sensor method, the same number of sensors as the number of selectable towers is required for each heliostat. Further, there is limit in a sensitivity range of the sensor. Therefore, the control based only on this method is difficult. Accordingly, this method is usually used in combination with the calendar method.

An example of a heliostat orientation controlling method using the calendar method will be described below. However, the heliostat orientation controlling method is not limited to this method. In accordance with the following steps, calculation is performed, in which, when seen from the heliostat, S is a directional vector of the sun and F is a directional vector to a target point on the tower.

Step S1: In accordance with the following expression, a heliostat directional vector (normal vector) N is calculated.

$$N = (S + F) / |S + F|$$

Step S2: Since the orientation of the heliostat is controlled by an azimuth A and an elevation angle E, the respective values are calculated.

$$E = asin(N.z)$$

$$A = atan(N.y / N.x) \quad (\text{Range of A is 0 degree to 360 degrees})$$

Step S3: Based on the values obtained in Step S2, the heliostat is controlled so as to be in the calculated orientation.

Step S4: The above steps are repeated with change of the solar directional vector, and the orientation of the heliostat is sequentially changed accordance with the change of the solar directional vector.

In the invention, assuming that the heliostat in a given position collects the light toward a given tower when the sun is in a given position, the quantity of light collected on a receiver of the given tower may be obtained, not necessarily through an actual measurement, but by finding a relation between the solar position and a tower to be selected in advance through calculation using a light collecting simulator.

In the beam-down light collecting system, the sunlight reflected by the heliostat 1 is reflected again by the reflector 2 of the tower 4 and is collected on the receiver 3. Nevertheless, the quantity of light received on the heliostat 1 is not the same as the quantity of light received on the receiver 3, and decreases due to various factors. By performing light collecting calculation, these factors are taken into consideration, and the quantity of light to be received on the receiver 3 is obtained.

The light collecting calculation is performed, for example, by a ray tracing method in which each light ray of the sun is traced one by one in accordance with the procedure of the following steps.

Here, the light ray is what puts three elements together, namely a pass point (a point on the ray including a starting point and an end point) p, a directional vector v, and intensity e.

Procedure of light-collection calculating method (light-collection calculation with a given solar position)

Step T1: Tracing a light ray which is emitted from a given position on the solar surface (because the sun is not a point light source but a surface light source) and reaches a given position (determination of initial light ray vector).
Step T2: Determining whether the light ray hits a given heliostat (Cosine factor).
Step T3: Determining whether the light ray is shielded, before reaching the given heliostat, by another heliostat or other obstacles (Shadowing).
Step T4: Reflecting the light ray by the heliostat (primary reflected ray) (Attenuation based on reflectance and cleanliness; Variation of reflection angle due to mirror installation error, and the like)
Step T5: Determining whether the primary reflected ray is shielded by another heliostat or other obstacles (Blocking).
Step T6: Determining whether the primary reflected ray hits a reflector (Spillage in reflector).
Step T7: Reflecting the primary reflected ray by a central reflection mirror (secondary reflected ray) (Attenuation based on reflectance, cleanliness and air; Variation in reflection angle due to mirror installation error, and the like)
Step T8: Determining whether the secondary reflected ray enters a receiver opening (Spillage in receiver).
Step T9: The secondary reflected ray reaching a receiver (Attenuation by air).
Step T10: Repeating the above steps

In the invention, the processing of comparing the magnitude of light collecting quantity, assuming that a given heliostat receives the light from the sun in a given position, between receivers of two optional neighboring towers, and selecting the tower in which the light collecting quantity is larger, may be performed by means of a simulator. When selecting the tower using a simulator, a light collecting simulator is used, receiver light-receiving-quantity calculation, whole-sky division for tower selection, and receiver light-receiving-quantity comparison are performed and, thereafter, the tower selection is performed based on results of these processing. In the tower selection, the tower selection when the sun is in a given position is performed, and the sunlight is collected to the selected tower.

More specifically,
the receiver light-receiving-quantity calculation is a processing of calculating the light receiving quantity assuming that the heliostat reflects the sunlight toward each tower when the sun is in a given position;
the whole-sky division is a processing of, based on the result of the receiver light-receiving-quantity calculation, dividing the whole sky by a boundary, on a position of which the respective light receiving quantities of the adjacent towers are the same; and
the receiver light-receiving-quantity comparison is a processing of comparing the light quantity to be received the receiver in each area of the whole sky divided by the whole-sky division, and indicating the tower in which the light receiving quantity is larger. In the tower selection, based on the result of the receiver light-receiving-quantity comparison, the tower determined to be large, when the sun is in a given position, in light receiving quantity is selected, the orientation of the heliostat is controlled so that the heliostat reflects the sunlight toward the selected tower, and the sunlight received by the heliostat is reflected toward the selected tower.

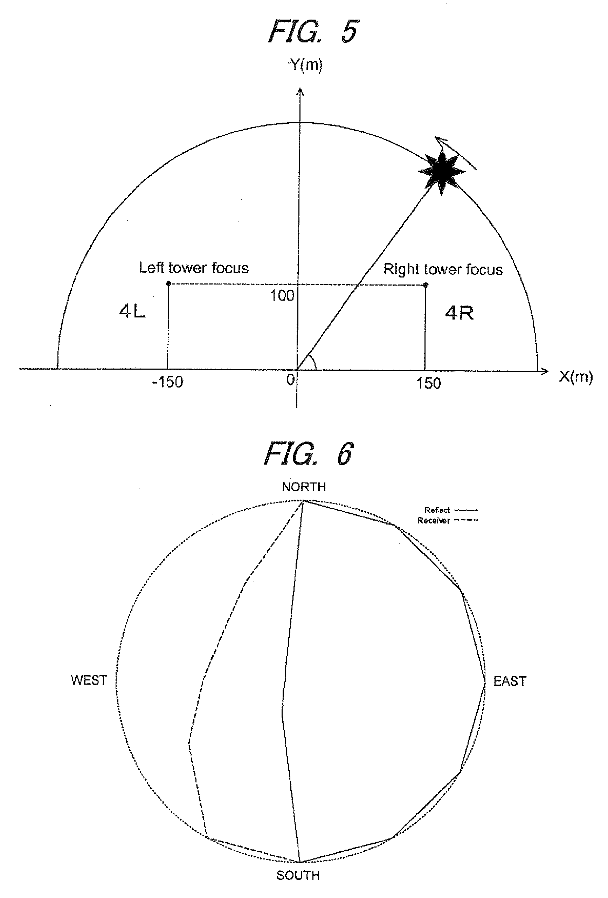

As a calculation example of the tower selection by means of the light collecting simulator, a case where two towers are arranged east and west will be described below (see Fig. 5).
- Calculation Conditions
Tower position: Tower 4L (-150, 0, 100), Tower 4R (150, 0, 100)
Heliostat position: (50, 50, 0)
Setting of heliostat focal distance: 150m
(Distance at which the reflection light from the heliostat focuses an image: the heliostat forms a pseudo concave mirror by a plurality of facet mirrors.)

(1) Receiver Light-Receiving-Quantity Calculation:

The light receiving quantity of the receiver in each tower when the sun is in a position of a given solar elevation and a given solar orientation has been found by calculation and a result of table 1 has been obtained. In the table 1, Azimuth represents a solar orientation angle (deg), Elevation is a solar elevation angle (deg), H1ref represents the light reflection quantity in case that the light is collected to the tower 4L, H1rec represents the receiver light receiving quantity in case that the light is reflected by the tower 4L, H2ref represents the heliostat light reflection quantity in case that the light is reflected to the tower 4R, and H2rec is the receiver light receiving quantity in case that the light is reflected to the tower 4R. Further, in the table 1, the east is taken as an origin (0 degree), the north is taken as 90 degrees, the west is taken as 180 degrees, and the south is taken as 270 degrees. Further, the heliostat light-refection quantity is described as reference.

[Table 1]

Table 1: Relation between solar position and light collecting quantity in each tower

| Azimuth | Elevation | H1ref | H1rec | H2ref | H2rec |
|---|---|---|---|---|---|
| 0 | 10 | 387.107 | 111.348 | 818.153 | 721.408 |
| 0 | 30 | 722.318 | 264.046 | 1552.12 | 1373.04 |
| 0 | 50 | 996.741 | 476.059 | 1605.81 | 1420.28 |
| 0 | 70 | 1211.01 | 605.066 | 1575.43 | 1392.81 |
| 0 | 90 | 1381.06 | 732.076 | 1497.86 | 1313.85 |
| 30 | 10 | 400.628 | 113.258 | 1232.86 | 1078.77 |
| 30 | 30 | 732.622 | 270.056 | 1473.2 | 1298.84 |
| 30 | 50 | 1000.5 | 482.421 | 1517.26 | 1339.68 |
| 30 | 70 | 1205.42 | 605.175 | 1532.73 | 1350.64 |
| 30 | 90 | 1382.77 | 733.951 | 1489.51 | 1308.01 |
| 60 | 10 | 637.249 | 240.888 | 1066.38 | 891.28 |
| 60 | 30 | 870.539 | 372.101 | 1345.8 | 1159.97 |
| 60 | 50 | 1099.73 | 555.989 | 1432.51 | 1252.26 |
| 60 | 70 | 1256.74 | 671.049 | 1481.53 | 1298.95 |
| 60 | 90 | 1379.92 | 731.819 | 1494.19 | 1310.74 |
| 90 | 10 | 537.104 | 259.238 | 622.865 | 479.06 |
| 90 | 30 | 1152.33 | 582.08 | 1160.49 | 926.496 |
| 90 | 50 | 1254.83 | 675.23 | 1313.84 | 1117.27 |
| 90 | 70 | 1329.92 | 729.002 | 1413.87 | 1229.91 |
| 90 | 90 | 1386.68 | 736.765 | 1489.63 | 1307.18 |
| 120 | 10 | 1122.59 | 614.479 | 686.932 | 359.932 |
| 120 | 30 | 1368.38 | 740.107 | 1006.47 | 690.428 |
| 120 | 50 | 1410.18 | 775.2 | 1208.37 | 976.036 |
| 120 | 70 | 1411.49 | 774.331 | 1368.6 | 1175.46 |
| 120 | 90 | 1380.99 | 733.381 | 1494.17 | 1311.5 |
| 150 | 10 | 1298.5 | 726.513 | 616.878 | 271.147 |
| 150 | 30 | 1515.53 | 818.465 | 928.588 | 580.749 |
| 150 | 50 | 1518.28 | 825.833 | 1165.5 | 908.623 |
| 150 | 70 | 1472.55 | 802.038 | 1352.93 | 1157.21 |

(continued)

| Azimuth | Elevation | H1ref | H1rec | H2ref | H2rec |
|---|---|---|---|---|---|
| 150 | 90 | 1382.05 | 731.96 | 1490.44 | 1306.51 |
| 180 | 10 | 818.153 | 486.185 | 596.38 | 319.166 |
| 180 | 30 | 1532.76 | 820.542 | 980.201 | 646.047 |
| 180 | 50 | 1578.88 | 846.465 | 1191.85 | 957.465 |
| 180 | 70 | 1512.52 | 816.713 | 1363.41 | 1168.66 |
| 180 | 90 | 1384.49 | 735.477 | 1490.01 | 1307.22 |
| 210 | 10 | 1392.83 | 763.178 | 819.831 | 571.754 |
| 210 | 30 | 1607.49 | 856.642 | 1118.98 | 885.979 |
| 210 | 50 | 1589.52 | 848.509 | 1282.89 | 1087.7 |
| 210 | 70 | 1509.99 | 813.816 | 1406.05 | 1218.9 |
| 210 | 90 | 1381.45 | 733.063 | 1495.52 | 1312.11 |
| 240 | 10 | 1299.37 | 719.02 | 1031.55 | 843.348 |
| 240 | 30 | 1519.1 | 821.573 | 1296.54 | 1106.12 |
| 240 | 50 | 1520.06 | 823.841 | 1404.77 | 1226.27 |
| 240 | 70 | 1472.05 | 803.354 | 1467.1 | 1286.72 |
| 240 | 90 | 1382.28 | 734.209 | 1489.57 | 1306 |
| 270 | 10 | 655.82 | 366.929 | 765.71 | 672.311 |
| 270 | 30 | 1352.06 | 730.564 | 1453.26 | 1276 |
| 270 | 50 | 1394.38 | 765.643 | 1523.65 | 1342.85 |
| 270 | 70 | 1409.34 | 772.71 | 1530.19 | 1346.49 |
| 270 | 90 | 1384.16 | 734.556 | 1492.39 | 1308.74 |
| 300 | 10 | 905.019 | 443.264 | 1335.93 | 1176.92 |
| 300 | 30 | 1138.19 | 573.582 | 1573.53 | 1390.71 |
| 300 | 50 | 1242.71 | 661.241 | 1601.43 | 1415.84 |
| 300 | 70 | 1328.35 | 724.13 | 1568.51 | 1384.77 |
| 300 | 90 | 1383.42 | 731.767 | 1495.13 | 1311.45 |
| 330 | 10 | 585.233 | 221.102 | 1367.5 | 1206.57 |
| 330 | 30 | 897.412 | 382.687 | 1618.07 | 1430.86 |
| 330 | 50 | 1092.07 | 552.002 | 1634.83 | 1444.97 |
| 330 | 70 | 1256.41 | 662.566 | 1586.16 | 1400.28 |
| 330 | 90 | 1383.15 | 733.239 | 1499.22 | 1315.26 |

(2) Whole-Sky Division:

In this processing, from the result of the table 1, regarding the relation between the tower to be selected and the solar position, the solar elevation at which the receiver light receiving quantity (H1rec) of the tower 4L and the receiver light receiving quantity (H2rec) of the tower 4R become the same is found for each solar orientation, and the whole sky is divided by a boundary line connecting the obtained elevation positions. Here, from the solar elevation and the light receiving quantity (Table 1), the solar elevation at which the light collecting quantity of each tower becomes the same is found for each solar orientation. The results are shown in Table 2.
[Table 2]

Table 2: Relation between solar orientation and solar elevation at which light collecting quantities of towers 1 and 2 become the same

| Azimuth | Even ref | Even rec |
|---|---|---|
| 0 | 0 | 0 |
| 30 | 0 | 0 |
| 60 | 0 | 0 |
| 90 | 0 | 0 |
| 120 | 75.49625 | 33.96615 |
| 150 | 80.49252 | 44.83379 |
| 180 | 81.7119 | 42.22403 |
| 210 | 79.53534 | 27.34219 |
| 240 | 70.88204 | 0 |
| 270 | 0 | 0 |
| 300 | 0 | 0 |
| 330 | 0 | 0 |

The results in the Table 2 are expressed in polar coordinate in which the zenith is taken as zero, as shown in Table 3 (In the elevation angle, a ground level is taken as 0 degree and the zenith is taken as 90 degrees. In the polar coordinate, the zenith is taken as 0 degree and the ground level is taken as 90 degrees.) Further, the table 3 is plotted with the polar coordinate as shown in Fig. 6.
Here, a circle shows the whole sky. A center is the zenith and the circumference becomes the ground level. When the sun lies in the position of a dotted line, the receiver light receiving quantity in each tower in case that the heliostat reflects the sunlight toward each tower becomes equal. When the sun lies in the position of a solid line, the reflection quantity from the heliostat in case that the heliostat reflects the sunlight toward each tower becomes equal. In the actual case, by shortening each interval of the azimuth and the elevation angle in this calculation, more exact figure can be created.
[Table 3]

Table 3: Relation between solar orientation and solar elevation at which light collecting quantities of towers 4L and 4R become the same (polar coordinate)

| Azimuth | Even ref | Even rec |
|---|---|---|
| 0 | 90 | 90 |
| 30 | 90 | 90 |
| 60 | 90 | 90 |
| 90 | 90 | 90 |
| 120 | 14.50375 | 56.03385 |
| 150 | 9.507478 | 45.16621 |
| 180 | 8.288104 | 47.77597 |
| 210 | 10.46466 | 62.65781 |
| 240 | 19.11796 | 90 |
| 270 | 90 | 90 |
| 300 | 90 | 90 |
| 330 | 90 | 90 |

(3) Receiver Light-Receiving-Quantity Comparison:

The light receiving quantity (H1rec, H2rec) in relation to the solar azimuth is compared between the respective towers, and the magnitude of the light receiving quantity is evaluated. Firstly, from the Table 1, it is found that: when the azimuth is 0, 30, 60, 90, 240, 270, 300, or 330 degrees, the light receiving quantity H1rec is always smaller than the light receiving quantity H2rec. Namely, when the solar orientation is in this range, it is better that the tower 4R is always selected. Here, for convenience sake, the elevation at which the light receiving quantity becomes the same is taken as 0 degree.

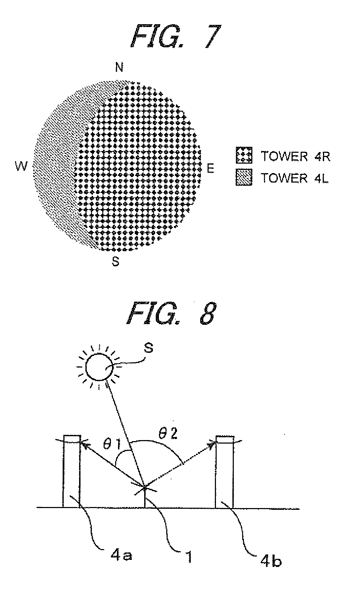

Next, from the Table 1, it is found that: when the azimuth is 120, 150, 18(l, or 210 degrees and when the solar elevation is low, the light receiving quantity H1rec is larger than the light receiving quantity H2rec; and when the solar elevation is high, the light receiving quantity H1rec is smaller than the light receiving quantity H2rec. Considering this result, the tower having the larger light receiving quantity in each of the divided areas of the whole sky is as shown in Fig. 7.

(4) Tower Selection: When the sun is in a given position, a tower to be selected can be selected by means of Fig. 7.

Further, though the light collecting quantity decreases due to various factors in the light calculation, it is also possible to perform simply the tower selection in consideration of the decrease due to only a cosine factor of their factors. In this case, it can be said that the tower selection is processing of performing control so that an angle formed by the sun and each upper focus becomes small.

Namely, as shown in Fig. 8, comparison is performed between an angle $\theta1$ formed by the sun S and a neighboring tower 4a when seen from a given heliostat 1, and an angle $\theta2$ formed by the sun S and another neighboring tower 4b. In case that $\theta1 < \theta2$, the tower 4a is selected, whereby the reflection amount from the heliostat is made substantially largest and the effective use of solar energy can be made. However, the light receiving quantity of the receiver is determined by other many factors. Therefore, in this case, compared with the case where the tower selection is rigorously performed by means of the light collecting simulator, the light collecting quantity decreases.

Next, regarding how effective such the tower selection in consideration of the decrease due to only such the cosine factor is, in the multi-tower beam-down light collecting system, in the example where such a tower that the angle formed by the sun and each tower seen from the heliostat becomes small is selected and the sunlight is collected to the selected tower, the calculation has been performed using the model in Fig. 5 described before. In Fig. 5, an X-axis represents an east-west direction, and a Y-axis represents a zenith direction. It is assumed that: on an X-Y plane, the sun rises from the east at 6:00 a.m., passes through the zenith at 12:00, and sinks at 6:00 p.m.

Here, the direct normal irradiance (DNI) is taken as 1.0 kW/m$^2$, the two towers are set respectively in the position of X = 150m and in the position of X = -150m, and the positions (heights of upper focus) of the reflectors in the both towers are taken as Y = 100m. The area of a mirror per heliostat is taken as 1.0m$^2$, and the thirty heliostats have been arranged between the both towers. Blocking and shadowing among the heliostats are not taken into consideration.

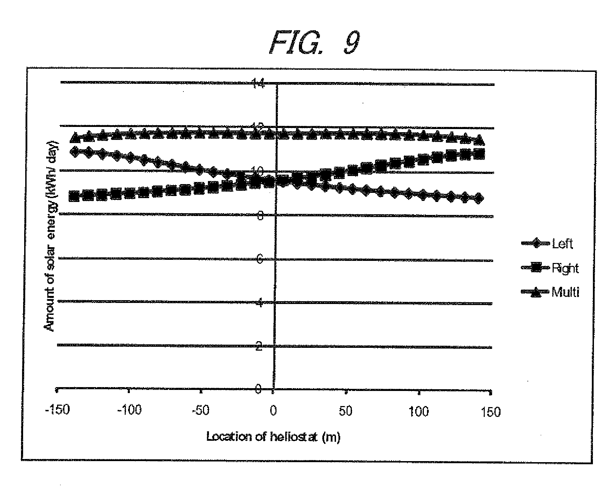

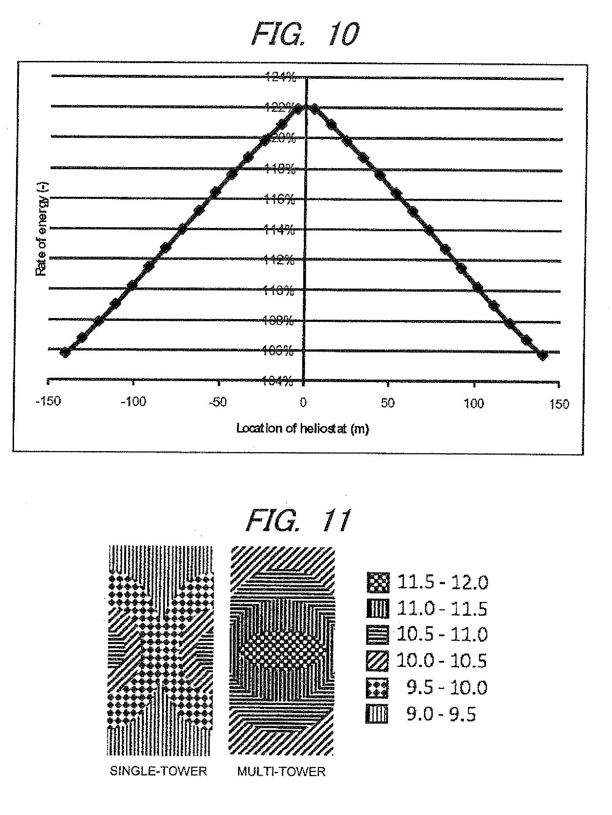

Fig. 9 shows the reflected energy quantity of the heliostat in a day. O-mark shows the reflected energy quantity in case that the heliostat collects the light to the left tower, and □-mark shows the reflected energy quantity in case that the heliostat collects the light to the right tower. Δ-mark shows the reflected energy quantity in case that the tower in which the angle formed by the reflector (upper focus) and the sun which are seen from the heliostat becomes small is selected as needed. Further, Fig. 10 shows the rate of the reflected energy quantity increased by performing the tower selection. As clear from these results, it has been found that the reflected energy quantity of each heliostat in a day increases by 5% to 22% due to the tower selection, compared with the case of the single-tower light collecting system. At the same time, it has been found that the heliostat located in an intermediate point between the two towers is highest in rate of its increase.

Further, Fig. 11 shows the reflected energy quantity of the heliostat in a day. In this figure, the towers are located on both sides of a rectangular filed. Fig. 11(a) shows the reflected energy quantity in case of a single-tower light collecting system, and (b) shows the reflected energy quantity in case that the tower in which the angle formed by the reflector (upper focus) and the sun which are seen from the heliostat becomes small is selected as needed. It has been found from this figure that the area of a region where the reflection quantity from one heliostat becomes 10.5kWh and more is about 13 times, compared with that in the single-tower light collecting system.

Than the above simple tower selection, the tower selection by means of the result of the elevation calculation and the result of the light receiving quantity comparison in Figs. 6 and 7 becomes more suitable. Namely, as clear from Fig. 6, in comparison between a case (solid line) where the tower light receiving quantity becomes simply equal in consideration of only the angle and a case (dashed line) where the tower light receiving quantity becomes equal by performing the elevation calculation, the area of region surrounded by the dashed line where the light is reflected toward the tower 4R is larger than that surrounded by the solid line, the tower selection is appropriately performed there and the tower light receiving quantity becomes larger.

As described above, in the invention, in case that the sun is in a given position, the light collecting calculation is performed and the tower selection is performed. In case that the invention is actually applied to the control of heliostat, such the calculation is performed in advance and its calculation result can be used also in control of the heliostat operation.

Further, by simultaneously carrying out the high-speed calculation processing of the light collecting simulator during the heliostat operation, when the light of the sun lying in the solar position at that time is received, during the operation, the magnitude of the light collecting quantities of the receivers in the two optional towers near the heliostat is evaluated, whereby the processing of selecting the tower in which the light collecting quantity is large may be performed. When the tower selection is performed by simultaneously performing the high-speed calculation processing of the light collecting simulator, the receiver light-receiving-quantity calculation is performed by the light collecting simulator, and the tower selection is performed on the basis of the result of the receiver light-receiving-quantity comparison. Therefore, the whole-sky division may be applied as needed.

INDUSTRIAL APPLICABILITY

The sunlight, as a renewable energy source, has an enormous quantity of energy, and is a clean energy source which has no environment pollution. The sunlight enables fuel production which utilizes the concentrated solar thermal energy in endothermic reaction of chemical reaction, and the stable supply of the generated electric power by concentrating the thin solar energy as the solar thermal power generation system. Further, by applying the sunlight to technology of synthesizing methanol from hydrogen and carbon monoxide which have been manufactured by coal gasification and natural gas steam reforming, it is possible to manufacture methanol of which heat quantity is 6-10% or more larger than total heat quantity of coal and methane of raw materials, and the sunlight is greatly expected as what can significantly reduce remission of carbon dioxide in the methanol manufacturing process.

DESCRIPTION OF REFERENCE SIGNS

1    Heliostat
2    Reflector
3    Receiver
4    Tower
5    Mirror
6    Mirror Surface

**Claims**

1. A solar light collecting method in a multi-tower beam-down light collecting system, comprising a tower selection, wherein the multi-tower beam-down light collecting system is a system in which, in a field where a plurality of beam-down light collecting towers are present, light primarily reflected by a heliostat is secondarily reflected by a reflector at a top part of one of the towers and is collected on a receiver on the ground, and
wherein the tower selection comprises comparing, assuming that the heliostat in a given position receives sunlight and reflects the sunlight toward each of optionally selected two of the towers, a light receiving quantity on the receiver of each of the towers, and selecting one of the towers in which the light receiving quantity is relatively large to reflect the sunlight toward said one of the towers.

2. The solar light collecting method in the multi-tower beam-down light collecting system as set forth in claim 1, wherein, in the tower selection comprises comparing, assuming that the heliostat in the given position receives the sunlight and reflects the sunlight toward each of the optionally selected two of the towers, an angle formed by an directional vector of incident light and a directional vector of reflection light seen from the heliostat, evaluating the magnitude of the angle formed by the directional vector of the incident light and the directional vector of the reflection light seen from the heliostat, determining that a tower with respect to which the angle formed by the directional vector of the incident light and the directional vector of the reflection light seen from the heliostat is smaller is the tower in which the light receiving quantity is relatively large, and selecting said tower.

3. The solar light collecting method in the multi-tower beam-down light collecting system as set forth in claim 1, wherein the tower selection is performed based on results of a receiver light-receiving-quantity calculation, a whole-sky division, and a receiver light-receiving-quantity comparison,
wherein the receiver light-receiving-quantity calculation comprises calculating a light receiving quantity in each receiver assuming that a given heliostat reflects the sunlight toward each tower when the sun is in a given position,
wherein the whole-sky division comprises finding, based on the result of the receiver light-receiving-quantity calcu-

EP 2 320 154 A1

lation, a boundary line on the whole sky along which the light receiving quantity in each receiver becomes the same assuming that the given heliostat reflects the sunlight toward each tower, and dividing the whole sky by the boundary line,
wherein the receiver light-receiving-quantity comparison comprises, with respect to each area of the whole sky divided by the whole-sky division, comparing the light receiving quantity to be received by the receiver of each tower assuming that the heliostat reflects the light toward each tower, and evaluating the magnitude of the light receiving quantity to be received by the tower, and
wherein the tower selection comprises determining, based on the result of the receiver light-receiving-quantity comparison, which tower is to be selected when the sun is in the given position, controlling an orientation of the heliostat so that the heliostat reflects the sunlight toward the tower that is determined to be large in light receiving quantity, and reflecting the sunlight received by the heliostat toward the selected tower.

4. The solar light collecting method in the multi-tower beam-down light collecting system as set forth in claim 3, wherein the receiver light-receiving-quantity calculation comprises calculating the light receiving quantity to be received by the receiver of each towers assuming that the heliostat reflects the sunlight toward each tower when the sun is in a position of a given solar orientation and a given solar elevation.

5. The solar light collecting method in the multi-tower beam-down light collecting system as set forth in claim 3, wherein the receiver light-receiving-quantity calculation comprises calculating the light receiving quantity to be received by the receiver of each towers assuming that the heliostat reflects the sunlight toward each tower when the sun is in a position of a given solar orientation and a given solar elevation; and
wherein the whole-sky division comprises finding a solar elevation at which the light receiving quantity to be received by the receiver of each towers adjacent to each other becomes the same in the given solar orientation to find the boundary line along which the light receiving quantity to be received by the receiver of each towers adjacent to each other becomes the same, and dividing the whole sky by the boundary line.

6. The solar light collecting method in the multi-tower beam-down light collecting system as set forth in claim 1, wherein the tower selection is performed based on results of a receiver light-receiving-quantity calculation and a receiver light-receiving-quantity comparison;
wherein the receiver light-receiving-quantity calculation comprises calculating the light receiving quantity to be received by the receiver of each tower assuming that a given heliostat reflects the sunlight toward each tower when the sun is in a given position;
the receiver light-receiving-quantity comparison comprises comparing, based on the result of the receiver light-receiving-quantity calculation, the light receiving quantity to be received by the receiver of each tower assuming that reflection is made toward each tower; and
the tower selection comprises determining, based on the result of the receiver light-receiving-quantity comparison, which tower is to be selected, controlling an orientation of the heliostat so that the heliostat reflects the sunlight toward the tower that is determined to be large in the light receiving quantity to be received by the receiver, and reflecting the sunlight received by the heliostat toward the selected tower.

7. The solar light collecting method in the multi-tower beam-down light collecting system as set forth in claim 1, wherein two or more towers are arranged at intervals among a group of heliostats dispersedly arranged on the ground, and each of the heliostats selects, in accordance with the tower selection, a specified tower such that the light receiving quantity to be received by the receiver becomes the largest.

## FIG. 1

2 REFLECTOR

4 TOWER

1 HELIOSTAT

3 RECEIVER

## FIG. 2

5 MIRROR

1

FRONT FACE

BACK FACE

FIG. 3

2

b1

6 MIRROR
SURFACE

4

*FIG. 4(a)*

*FIG. 4(b)*

## FIG. 5

## FIG. 6

## FIG. 7

TOWER 4R
TOWER 4L

## FIG. 8

## FIG. 9

## FIG. 10

## FIG. 11

| | |
|---|---|
| ▦ | 11.5 - 12.0 |
| ▥ | 11.0 - 11.5 |
| ☰ | 10.5 - 11.0 |
| ▨ | 10.0 - 10.5 |
| ⦂⦂ | 9.5 - 10.0 |
| ▥ | 9.0 - 9.5 |

SINGLE-TOWER    MULTI-TOWER

FIG. 12

FIG. 13

| **INTERNATIONAL SEARCH REPORT** | | International application No. |
|---|---|---|
| | | PCT/JP2009/063154 |

**A. CLASSIFICATION OF SUBJECT MATTER**
F24J2/18(2006.01)i, F24J2/38(2006.01)i, G02B7/182(2006.01)i, H01L31/042
(2006.01)n

According to International Patent Classification (IPC) or to both national classification and IPC

**B. FIELDS SEARCHED**

Minimum documentation searched (classification system followed by classification symbols)
F24J2/18, F24J2/38, G02B7/182, H01L31/042

Documentation searched other than minimum documentation to the extent that such documents are included in the fields searched
Jitsuyo Shinan Koho          1922–1996   Jitsuyo Shinan Toroku Koho   1996–2009
Kokai Jitsuyo Shinan Koho    1971–2009   Toroku Jitsuyo Shinan Koho   1994–2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2951297 B2   (Mitaka Kohki Co., Ltd.), 20 September 1999 (20.09.1999), entire text; all drawings (Family: none) | 1–7 |
| A | JP 2000-146310 A  (Mitaka Kohki Co., Ltd.), 26 May 2000 (26.05.2000), entire text; all drawings & JP 2989179 B | 1–7 |
| A | JP 2004-037037 A  (Mitaka Kohki Co., Ltd.), 05 February 2004 (05.02.2004), entire text; all drawings & US 2004/0004175 A1 | 1–7 |

☒ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 October, 2009 (16.10.09) | 27 October, 2009 (27.10.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/063154

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-111090 A  (Shirouma Science Co., Ltd.), 20 April 2001 (20.04.2001), entire text; all drawings (Family: none) | 1-7 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2951297 B
- JP 2000146310 A
- JP 2004037037 A